# EUROPEAN PATENT SPECIFICATION

(11) **EP 2 746 201 B1**
(45) Date of publication and mention of the grant of the patent: **30.09.2015**
(21) Application number: 12008510.5
(22) Date of filing: 21.12.2012
(51) Int. Cl.: B65G 54/02, H01L 21/677

(54) **Apparatus and method for conveying carriers in a machine**
Vorrichtung und Verfahren zur Förderung von Trägern in einer Maschine
Appareil et procédé pour transporter des supports dans une machine

(43) Date of publication of application: 25.06.2014
(73) Proprietor: ROBERT BOSCH GMBH, 70442 Stuttgart (DE)
(72) Inventor: Haring, Menno, NL-5615RE Eindhoven (NL)
(74) Representative: Thürer, Andreas

(56) References cited:
- EP-A2- 0 246 098
- EP-B1- 0 452 375
- DE-A1-102011 003 682
- US-A- 5 047 676
- US-A- 5 906 262

## Description

The present invention relates to a conveying apparatus and a conveying method for conveying carriers in a machine.

In machines for producing an article, conveying systems are used to convey parts, tools, etc., which are usable for the production of the article, to different stations of the machine. Such machines are described, for example, in US 2004/0049308 A1 which discloses an assembly for processing substrates, in which a conveying device for moving the substrates from a vacuum lock to a process chamber is provided. Anodes example is described in US5906262.

In such machines for producing an article, carriers are conveyed by the use of magnetic force. The magnetic force can be produced by coils fixedly arranged in one or more tracks along which the carriers travel. However, since there are different zones in the machine, like a process chamber or the area outside the process chamber, etc. the carriers and the coils are not always visible for a person monitoring the production process.

A detection of the position of the carriers can be performed by the use of hall sensors assigned to the coils of the conveying system. However, there is a problem that the correct function of the hall sensors is not easy to determine. In case a hall sensor is broken or the electric power provided for the hall sensor is too low or too high, this fact will remain undetected unless the hall sensor is serviced. That instance produces high maintenance costs and is not acceptable in view of the required secure operation of the conveying system and thus the machine for producing an article.

Therefore, it is an object of the present invention to provide a conveying apparatus and a conveying method for conveying carriers in a machine, with which apparatus and method the above-mentioned problems can be solved. In particular, a conveying apparatus and a conveying method for conveying carriers in a machine shall be provided, in which a service of a magnetic sensor is simplified and thus less expensive.

This object is solved by a conveying apparatus for controlling a machine according to claim 1. The conveying apparatus comprises: at least one coil for conveying a carrier by the use of magnetic force, and at least one magnetic sensor assigned to one of the at least one coils and being for detecting the function of the assigned coil, and wherein at least one detecting device is electrically connected to detect a status of the at least one magnetic sensor.

With such a conveying apparatus, a servicing of the magnetic sensors is simplified, since the status thereof is known. Thus, the costs for servicing can be reduced, since no magnetic sensor is replaced even if the function thereof is still sufficient.

Moreover, the conveying apparatus secures that the position of the carriers in the machine is made visible.

Further advantageous developments of the conveying apparatus are set out in the dependent claims.

Preferably, each of the at least one detecting devices is arranged to detect whether the hardware of the magnetic sensor is broken and/or whether the power supply of the coil and/or the magnetic sensor is too high or too low.

It is possible that at least one detecting device and/or at least one magnetic sensor is further arranged to detect the position of one of the carriers.

It is also possible that two magnetic sensors and two detecting devices are assigned to one coil of the at least one coils.

At least one magnetic sensor of the at least one magnetic sensors can be a hall sensor.

The magnetic sensor can comprise two hall sensors, wherein the two hall sensors are electrically connected as the detecting device and are capable to detect the position of a carrier.

It is advantageous, when the detecting device is capable to display the status of the at least one magnetic sensor. Therewith, the status can be indicated for person like a user of the machine or maintenance personal.

Preferably, the detecting device being capable to display the status of the at least one magnetic sensor is arranged at one of the magnetic sensors. Therewith, the indication of the status of the magnetic sensor is allotted to the concerned magnetic sensor.

It is possible that the detecting device is arranged to display whether or not the magnetic sensor is malfunctioning.

Advantageously, the detecting device is a light emitting diode. Therewith, a person like a user of the machine or maintenance personal can visibly notice the status of the magnetic sensor. Further, the light emitting diode consumes only a little amount of electrical power so that the energy consumption of the machine is not increased significantly.

Preferably, the light emitting diode is a multicolor light emitting diode and each color of the multicolor light emitting diode is usable for indicating a predetermined status of the magnetic sensor. Thus, the allocation of the status is made very easy for a person like a user of the machine or maintenance personal.

The above-described conveying apparatus can be part of a machine for producing an article. Herein, the conveying apparatus can be at least partly arranged in a vacuum.

This object is further solved by a conveying method for conveying carriers in a machine according to claim 14. The conveying method comprises the following steps: conveying the carriers by the use of magnetic force produced by at least one coil, detecting the function of one of the at least one coil with at least one magnetic sensor assigned to said one coil, and detecting with at least one detecting device a status of the at least one magnetic sensor.

The conveying method achieves the same advantages as mentioned above for the conveying apparatus.

Further possible implementations of the invention also comprise combinations of specific features described above or in the following as regards the embodiments, even if they are not explicitly mentioned. Therefore, the person skilled in the art will also add single aspects as improvements or supplements to the basic form of the invention.

In the following, the present invention is described in more detail with the help of embodiments by reference to the appended drawings. The figures show:
Fig. 1 a side view of a machine comprising a conveying apparatus according to a first embodiment;
Fig. 2 a three-dimensional view of the machine of Fig. 1;
Fig. 3 a flow chart schematically illustrating a conveying method according to the first embodiment;
Fig. 4 a side view of a machine comprising a conveying apparatus according to a second embodiment; and
Fig. 5 a flow chart schematically illustrating a conveying method according to the second embodiment.

In the figures, similar elements or elements having similar function are marked with the same reference signs unless specified otherwise.

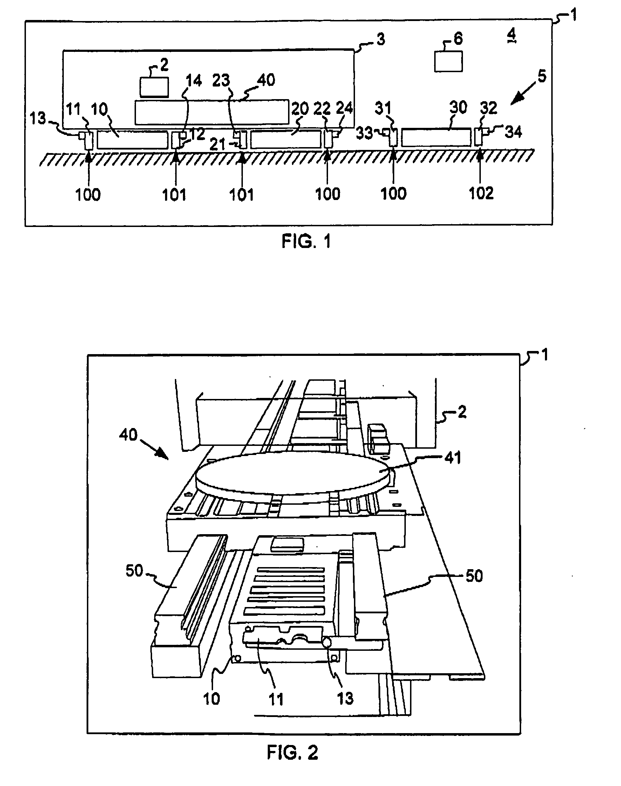

Fig. 1 shows a machine 1 for producing an article 2. The machine 1 comprises a process chamber 3, an area 4 outside of the process chamber 3, a conveying apparatus 5 arranged both in the process chamber 3 and the area 4 outside thereof, and a control device 6. In the process chamber 3, a vacuum can be present which can be required for the production of electronic articles, like chips on semiconductor wafers, etc. In this case, atmospheric pressure can be present in the area 4 outside of the process chamber 3. The control device 6 controls the processes performed in the process chamber 3 and the conveying apparatus 5.

In Fig. 1, the conveying apparatus 5 comprises a first coil 10, a second coil 20, a third coil 30 and a carrier 40. In Fig. 1, only the carrier 40 is arranged in the process chamber 3 whereas the other parts of the conveying apparatus 5 are arranged in the area 4 outside of the process chamber 3. Such an arrangement is preferable when a vacuum should be present in the process chamber 3.

The first to third coil 10, 20, 30 build up a track of the conveying apparatus 5. The carrier 40 is provided with magnetic elements (not shown) cooperating with the first to third coils 10, 20, 30, so that the carrier 40 is movable over the first to third coil 10, 20, 30 by magnetic force and the control performed by the control device 6. In other words, the carrier 40 is movable over the track of the conveying apparatus 5 from a first position to a second position different from the first position. For example, the first position is the position on the left side in Fig. 1, where the carrier 40 is arranged in Fig. 1. The second position could then be a position of the carrier 40 over the third coil 30, i.e. on the right side in Fig. 1.

To the first coil 10, a first magnetic sensor 11 and a second magnetic sensor 12 are assigned to detect the function of the first coil 10. At the first magnetic sensor 11 there is arranged a first detecting device 13. At the second magnetic sensor 12 there is arranged a second detecting device 14. To the second coil 20, a first magnetic sensor 21 and a second magnetic sensor 22 are assigned to detect the function of the second coil 20. At the first magnetic sensor 21 there is arranged a first detecting device 23. At the second magnetic sensor 22 there is arranged a second detecting device 24. To the third coil 30, a first magnetic sensor 31 and a second magnetic sensor 32 are assigned to detect the function of the third coil 30. At the first magnetic sensor 31 there is arranged a first detecting device 33. At the second magnetic sensor 32 there is arranged a second detecting device 34. The reference signs 100, 101, 102 each show a different status of the magnetic sensors 11, 12, 21, 22, 31, 32, as described in the following.

The magnetic sensors 11, 12, 21, 22, 31, 32 can be hall sensors. Besides a detection of the function of the assigned coils 10, 20, 30, the magnetic sensors 11, 12, 21, 22, 31, 32 can be used for detecting the position of the carrier 40 in the machine 1. The function of the coils 10, 20, 30 can be whether or not the specific coil 10, 20, 30 produces magnetic force.

The detecting devices 13, 14, 23, 24, 33, 34 each can detect the status of one of the magnetic sensors 11, 12, 21, 22, 31, 32. The status can be whether or not the power supply of the corresponding magnetic sensor 11, 12, 21, 22, 31, 32 is too high or too low. Thus, the detecting devices 13, 14, 23, 24, 33, 34 can detect whether or not the corresponding magnetic sensor 11, 12, 21, 22, 31, 32 is malfunctioning. In addition, the detecting devices 13, 14, 23, 24, 33, 34 can detect, whether or not the corresponding magnetic sensor 11, 12, 21, 22, 31, 32 detects a carrier 40.

For that purpose, the detecting devices 13, 14, 23, 24, 33, 34 are light emitting diodes (LEDs) which are each electrically connected with the corresponding magnetic sensor 11, 12, 21, 22, 31, 32 such that the light emitting diode (LEDs) can emit light only, when the power supply is sufficient. Further, the detecting devices 13, 14, 23, 24, 33, 34 are each electrically connected with the corresponding magnetic sensor 11, 12, 21, 22, 31, 32 such that they can indicate, for example by the emission of blue light, that the power supply of the corresponding magnetic sensor 11, 12, 21, 22, 31, 32 is too high. Further, the detecting devices 13, 14, 23, 24, 33, 34 are each electrically connected with the corresponding magnetic sensor 11, 12, 21, 22, 31, 32 such that they can indicate, for example by the emission of yellow light, that the corresponding magnetic sensor 11, 12, 21, 22, 31, 32 detects a carrier 40.

Thus, the detecting devices 13, 14, 23, 24, 33, 34 of the present embodiment are light emitting diodes (LEDs) able to emit light with different colors, i.e. multicolor light emitting diodes (LEDs). Due to this, the detecting devices 13, 14, 23, 24, 33, 34 of the present embodiment function as display devices, as well.

In the example of FIG. 1, the detecting devices 13, 14, 23, 24, 33, 34 implemented by light emitting diodes indicate at the status 100, that the corresponding magnetic sensor 11, 12, 21, 22, 31, 32 detects no carrier 40, at the status 101, that the corresponding magnetic sensor 11, 12, 21, 22, 31, 32 detects a carrier 40, and at the status 102, that the corresponding magnetic sensor 11, 12, 21, 22, 31, 32 is malfunctioning because the power supply thereto is too high. Due to the arrangement of the magnetic sensors 11, 12, 21, 22, 31, 32 and the detecting devices 13, 14, 23, 24, 33, 34, the conveyance of the carrier 40 along their way over the first to third coils 10, 20, 30 can be made visible. And, the function of the magnetic sensors 11, 12, 21, 22, 31, 32 can be detected and made visible.

Fig. 2 illustrates in a three-dimensional view of the machine 1 in more detail the arrangement of the detecting device 13 at the corresponding magnetic sensor 11 assigned to the first coil 10. It is shown further that the carrier 40 comprises a plate 41 on which the articles and or parts thereof can be loaded. The carrier 40 is supported by and movable on tracks 50 over the first coil 10 and the other coils 20, 30 shown in Fig. 1.

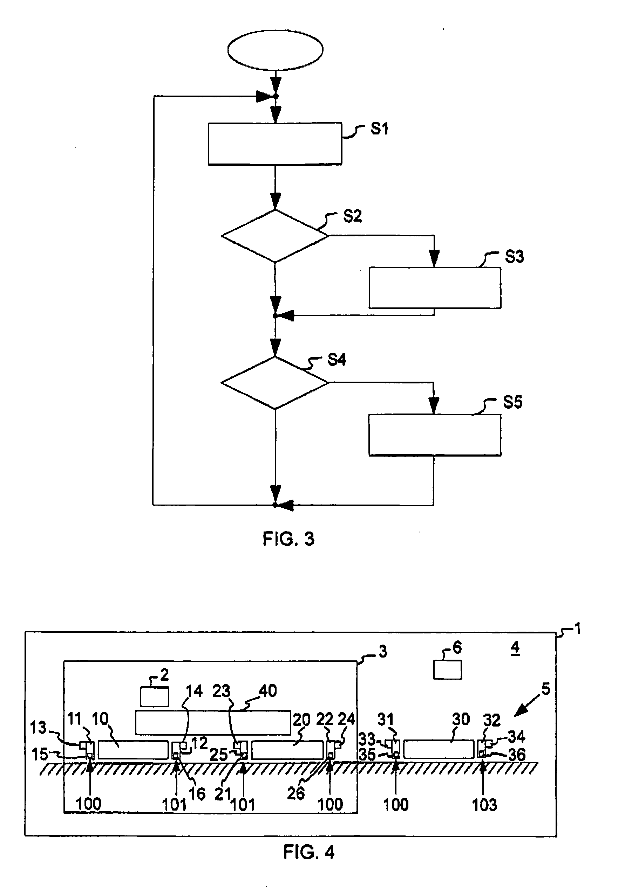

Fig. 3 shows a conveying method performed in the machine 1 for the conveying apparatus 5.

After the start of the conveying method, a carrier 40 is conveyed by one or all of the first to third coils 10, 20, 30 in a step S1. Thereafter, the flow continues to a step S2.

In the step S2, it is checked whether or not one of the magnetic sensors 11, 12, 21, 22, 31, 32 detects the carrier 40. In case the carrier 40 is detected by at least one magnetic sensor 11, 12, 21, 22, 31, 32, the flow continues as regards this magnetic sensor 11, 12, 21, 22, 31, 32 with a step S3. For the other magnetic sensors 11, 12, 21, 22, 31, 32 which detected no carrier 40, the flow continues with a step S4.

In the step S3, the concerned detecting device 13, 14, 23, 24, 33, 34 is controlled such that it displays, for example in a yellow color, that the carrier 40 is detected. Thereafter, the flow continues to the step S4.

In the step S4, it is checked whether or not one of the detecting devices 13, 14, 23, 24, 33, 34 detects that the power supply of the corresponding magnetic sensor 11, 12, 21, 22, 31, 32 is too high or too low. In case the power supply of the corresponding magnetic sensor 11, 12, 21, 22, 31, 32 is too high or too low, the flow continues with a step S5. Otherwise, the flow goes back to the step S1.

In the step S5, the detecting device 13, 14, 23, 24, 33, 34 is controlled such that it displays, for example in a blue color, that the power supply of the corresponding magnetic sensor 11, 12, 21, 22, 31, 32 is too high or does not emit any color to indicate that the power supply of the corresponding magnetic sensor 11, 12, 21, 22, 31, 32 is too low. Thereafter, the flow goes back to the step S1.

The conveying method finishes when the machine 1 is switched off.

In the present embodiment, the detecting devices 13, 14, 23, 24, 33, 34 implemented as light emitting diodes are used for detecting and displaying the status of the magnetic sensors 11, 12, 21, 22, 31, 32 and/or displaying the position of the carrier 40. The signal for the latter detection is received from the magnetic sensors 11, 12, 21, 22, 31, 32. Therewith, the servicing of the magnetic sensors 11, 12, 21, 22, 31, 32 can be simplified and the costs can be reduced. Further, the visibility of the carriers 40 in the machine 1 can be improved.

Fig. 4 shows a machine 1 according to a second embodiment, which machine 1 is usable for producing an article 2. As in the first embodiment, the machine 1 according to this embodiment comprises a process chamber 3, an area 4 outside of the process chamber 3 and a conveying apparatus 5.

In contrast to the machine 1 according to the first embodiment, the machine 1 according to the present embodiment further comprises further detecting devices 15, 16, 25, 26, 35, 36 shown in the magnetic sensors 11, 12, 21, 22, 31, 32. Further, not only the carrier 40 is arranged in the process chamber 3 in the present embodiment but also the coils 10, 20 and the corresponding magnetic sensors 11, 12, 21, 22 and detecting devices 15, 16, 25, 26. However, as in the first embodiment, the other parts of the conveying apparatus 5 are arranged in the area 4 outside of the process chamber 3 in the present embodiment. Such an arrangement can be chosen, in particular, when no vacuum is present in the process chamber 3.

The first further detecting device 15 is arranged in the first magnetic sensor 11 of the first coil 10. The second further detecting device 16 is arranged in the second magnetic sensor 12 of the first coil 10. The third further detecting device 25 is arranged in the first magnetic sensor 21 of the second coil 20. The fourth further detecting device 26 is arranged in the second magnetic sensor 22 of the second coil 20. The fifth further detecting device 35 is arranged in the first magnetic sensor 31 of the third coil 30. The sixth further detecting device 36 is arranged in the second magnetic sensor 32 of the third coil 30.

In the present embodiment, the detecting devices 13, 14, 23, 24, 33, 34 can again detect the status of the magnetic sensors 11, 12, 21, 22, 31, 32, as described with reference to the first embodiment. However, in the present embodiment, the first to sixth further detecting devices 15, 16, 25, 26, 35, 36 can detect a further status of the magnetic sensors 11, 12, 21, 22, 31, 32 as to whether or not the hardware of the magnetic sensors 11, 12, 21, 22, 31, 32 is broken. Here, each of the detecting devices 15, 16, 25, 26, 35, 36 is made up by two hall sensors. The hall sensors are the two hall sensors included in each of the magnetic sensors 11, 12, 21, 22, 31, 32 and used for detecting the position of the carrier 40 in the machine 1. For the further detecting devices 15, 16, 25, 26, 35, 36, the two hall sensors of the magnetic sensors 11, 12, 21, 22, 31, 32 are electrically connected such that it can be detected whether or not the hardware of the magnetic sensors 11, 12, 21, 22, 31, 32 is broken. Thus, the magnetic sensors 11, 12, 21, 22, 31, 32 are arranged such that they can monitor the function thereof by themselves.

In the example of FIG. 4, the detecting devices 13, 14, 23, 24, 33, 34 implemented by light emitting diodes indicate at the status 100, 101, 102 the same as mentioned above in the first embodiment with reference to Fig. 1. However, in the present embodiment, the magnetic sensor 32 is in the status 103, which is displayed by the corresponding detecting device 34 in red color, for example. The status 103 indicates that the concerned magnetic sensor 11, 12, 21, 22, 31, 32 is malfunctioning because its hardware is broken.

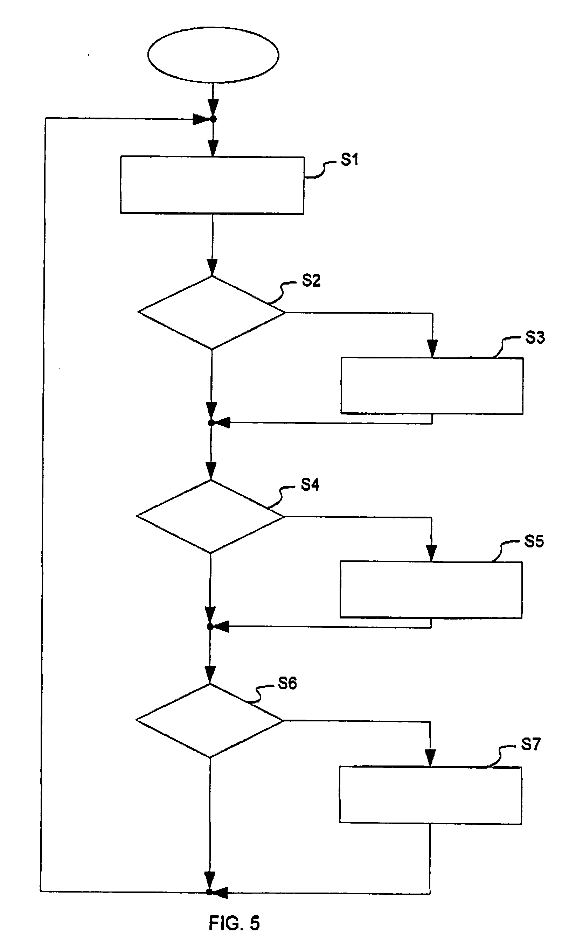

Fig. 5 shows a conveying method performed in the machine 1 for the conveying apparatus 5 according to this embodiment, in which the steps S1 to S5 are basically the same as described with reference to the first embodiment.

In addition, after the step S4 and the step S5, instead of the continuation with step S1 in the first embodiment, a step S6 is performed. In the step S6, the first to sixth further detecting devices 15, 16, 25, 26, 35, 36 detect whether or not the hardware of the magnetic sensors 11, 12, 21, 22, 31, 32 is broken. Herein, it can be determined, for example, whether or not only one of the two hall sensors arranged on a rotating plate delivers a signal. In case the hardware is broken, the flow continues with a step S7. In case, the hardware is not broken, the flow continues with the step S1.

In the step S7, the first to sixth further detecting devices 15, 16, 25, 26, 35, 36 build in the corresponding magnetic sensor 11, 12, 21, 22, 31, 32 control the corresponding detecting device 13, 14, 23, 24, 33, 34 to display, for example in a red color, that the hardware is broken. Thereafter, the flow goes back to the step S1.

Thus, the detecting devices 13, 14, 23, 24, 33, 34 and/or the first to sixth further detecting devices 15, 16, 25, 26, 35, 36 can detect the status of the corresponding magnetic sensor 11, 12, 21, 22, 31, 32, in particular, whether or not the corresponding magnetic sensor 11, 12, 21, 22, 31, 32 is malfunctioning.

All of the previously described implementation forms of the machine 1, the conveying apparatus 5 and the conveying method can be used separately or in all possible combinations thereof. In particular, the features of the first and second embodiments can be combined arbitrarily. In addition, the following modifications are conceivable.

The elements shown in the drawings are shown schematically and can differ in their actual implementation from the forms shown in the drawings whilst their above-described functions are ensured.

Even if it is described that the conveying apparatus 5 comprises a first to third coil 10, 20, 30, the first to third coil 10, 20, 30 can also be motors used to move or convey the carrier 40.

The number of the coils 10, 20, 30 forming a track of the conveying apparatus 5 can be selected arbitrarily. In addition, the number of tracks forming the conveying apparatus 5 can be selected arbitrarily.

The number of magnetic sensors 11, 12, 21, 22, 31, 32 assigned to one coil 10, 20, 30 can be selected arbitrarily. In addition, the number of detecting devices 13, 14, 23, 24, 33, 34 can be selected arbitrarily. It is also possible that only one magnetic sensor 11, 12, 21, 22, 31, 32 is assigned to one coil 10, 20, 30. It is also possible that not all of the magnetic sensors 11, 12, 21, 22, 31, 32 are provided with a detecting device 13, 14, 23, 24, 33, 34.

Even if it is described in the first and second embodiment that the detecting devices 13, 14, 23, 24, 33, 34 are arranged at the magnetic sensor the status of which they detect and display, this is not limiting. The detecting devices 13, 14, 23, 24, 33, 34 can also be arranged at another place where they are visible for a user of the machine etc.

The sequence of the steps S1, S2, S4, S6 of the conveying method of the first and second embodiment can be selected arbitrarily. The steps S4, S6, of detecting the status of the magnetic sensors 11, 12, 21, 22, 31, 32 and/or the step S1 of conveying and the step S2 of detecting the carrier 40 can be performed at least partly simultaneously.

The arrangement of the process chamber 3 relative to the conveying apparatus 5 and/or parts thereof can be selected as appropriate in both embodiments. Fig. 1 and Fig. 4 only show two specific arrangement possibilities in this regard and do not limit the present invention thereto.

The dimensions shown in the drawings are used for illustrating the principle of the invention and are not limiting. The actual dimensions of the machine 1 and the components thereof can be selected as appropriate.

## Claims

1. Conveying apparatus (5) for conveying carriers (40) in a machine (1), comprising at least one coil (10, 20, 30) for conveying a carrier (40) by the use of magnetic force, and at least one magnetic sensor (11, 12, 21, 22, 31, 32) assigned to one of the at least one coils (10, 20, 30) and being for detecting the function of the assigned coil (10, 20, 30), wherein at least one detecting device (13, 14, 23, 24, 33, 34; 13-16; 23-26, 33-36) is electrically connected to detect a status (100, 101, 102, 103) of the at least one magnetic sensor (11, 12, 21, 22, 31, 32).

2. Conveying apparatus (5) according to claim 1, wherein each of the at least one detecting devices (13, 14, 23, 24, 33, 34; 13-16; 23-26; 33-36) is arranged to detect whether the hardware of the magnetic sensor (11, 12, 21, 22, 31, 32) is broken and/or whether the power supply of the coil (10, 20, 30) and/or the magnetic sensor (11, 12, 21, 22, 31, 32) is too high or too low.

3. Conveying apparatus (5) according to claim 1 or 2, wherein the at least one detecting device (13, 14, 23, 24, 33, 34, 13-16; 23-26; 33-36) and/or the at least one magnetic sensor (11, 12, 21, 22, 31, 32) is further arranged to detect the position of one of the carriers (40).

4. Conveying apparatus (5) according to any one of the preceding claims, wherein two magnetic sensors (11, 12, 21, 22, 31, 32) and two detecting devices (13, 14, 23, 24, 33, 34) are assigned to one coil (10, 20, 30) of the at least one coils (10, 20, 30).

5. Conveying apparatus (5) according to any one of the preceding claims, wherein at least one magnetic sensor (11, 12, 21, 22, 31, 32) of the at least one magnetic sensors (11, 12, 21, 22, 31, 32) is a hall sensor.

6. Conveying apparatus (5) according to any one of the preceding claims, wherein the magnetic sensor (11, 12, 21, 22, 31, 32) comprises two hall sensors, and wherein the two hall sensors are electrically connected as the detecting device (15, 16, 25, 26, 35, 36) and are capable to detect the position of a carrier (40).

7. Conveying apparatus (5) according to any one of the preceding claims, wherein the detecting device (13, 14, 23, 24, 33, 34) is capable to display the status (100, 101, 102, 103) of the at least one magnetic sensor (11, 12, 21, 22, 31, 32).

8. Conveying apparatus (5) according to claim 7, wherein the detecting device (13, 14, 23, 24, 33, 34) is arranged at one of the magnetic sensors (11, 12, 21, 22, 31, 32).

9. Conveying apparatus (5) according to claim 7 or 8, wherein the detecting device (13, 14, 23, 24, 33, 34) is arranged to display whether or not the magnetic sensor (11, 12, 21, 22, 31, 32) is malfunctioning.

10. Conveying apparatus (5) according to any one of the claims 7 to 9, wherein the detecting device (13, 14, 23, 24, 33, 34) is a light emitting diode.

11. Conveying apparatus (5) according to claim 10, wherein the light emitting diode is a multicolor light emitting diode and wherein each color of the multicolor light emitting diode is usable for displaying a predetermined status (100, 101, 102, 103) of the magnetic sensor (11, 12, 21, 22, 31, 32).

12. Machine (1) for producing an article (2), comprising a conveying apparatus (5) according to any one of the preceding claims.

13. Machine (1) according to claim 12, wherein the conveying apparatus (5) is at least partly arranged in a vacuum.

14. Conveying method for conveying carriers (40) in a machine (1), comprising the steps of conveying (S1) the carriers (40) by the use of magnetic force produced by at least one coil (10, 20, 30), detecting (S2) the function of one of the at least one coil (10, 20, 30) with at least one magnetic sensor (11, 12, 21, 22, 31, 32) assigned to said one coil (10, 20, 30), and detecting (S3) with at least one detecting device (13, 14, 23, 24, 33, 34; 13-16; 23-26; 33-36) a status (100, 101, 102, 103) of the at least one magnetic sensor (11, 12, 21, 22, 31, 32).

## Patentansprüche

1. Transportvorrichtung (5) für Transportträger (40) in einer Maschine (1), die mindestens eine Magnetspule (10, 20, 30) zum Transportieren eines Trägers (40) durch die Anwendung einer Magnetkraft umfasst, und mindestens einen Magnetsensor (11, 12, 21, 22, 31, 32), der einer der mindestens einen Magnetspule (10, 20, 30) zugeordnet ist und zum Feststellen der Funktion der zugeordneten Magnetspule (10, 20, 30) verwendet wird, wobei mindestens eine Feststellungsvorrichtung (13, 14, 23, 24, 33, 34; 13-16; 23-26, 33-36) elektrisch angeschlossen ist, um einen Status (100, 101, 102, 103) des mindestens einen Magnetsensors (11, 12, 21, 22, 31, 32) festzustellen.

2. Transportvorrichtung (5) nach Anspruch 1, wobei jede der mindestens einen Feststellungsvorrichtungen (13, 14, 23, 24, 33, 34; 13-16; 23-26; 33-36) zum Feststellen ausgelegt ist, ob die Hardware des Magnetsensors (11, 12, 21, 22, 31, 32) defekt ist und/oder ob die Stromversorgung der Magnetspule (10, 20, 30) und/oder des Magnetsensors (11, 12, 21, 22, 31, 32) zu hoch oder zu niedrig ist.

3. Transportvorrichtung (5) nach Anspruch 1 oder 2, wobei die mindestens eine Feststellungsvorrichtung (13, 14, 23, 24, 33, 34, 13-16; 23-26; 33-36) und/oder der mindestens eine Magnetsensor (11, 12, 21, 22, 31, 32) ferner dafür ausgelegt ist, die Position von einem der Träger (40) festzustellen.

4. Transportvorrichtung (5) nach einem der vorherigen Ansprüche, wobei zwei Magnetsensoren (11, 12, 21, 22, 31, 32) und zwei Feststellungsvorrichtungen (13, 14, 23, 24, 33, 34) einer Magnetspule (10, 20, 30) der mindestens einen Magnetspule (10, 20, 30) zugeordnet sind.

5. Transportvorrichtung (5) nach einem der vorherigen Ansprüche, wobei mindestens ein Magnetsensor (11, 12, 21, 22, 31, 32) des mindestens einen Magnetsensors (11, 12, 21, 22, 31, 32) ein Hallsensor ist.

6. Transportvorrichtung (5) nach einem der vorherigen Ansprüche, wobei der Magnetsensor (11, 12, 21, 22, 31, 32) zwei Hallsensoren umfasst und wobei die zwei Hallsensoren elektrisch als die Feststellungsvorrichtung (15, 16, 25, 26, 35, 36) verbunden sind und in der Lage sind, die Position eines Trägers (40) festzustellen.

7. Transportvorrichtung (5) nach einem der vorherigen Ansprüche, wobei die Feststellungsvorrichtung (13, 14, 23, 24, 33, 34) in der Lage ist, den Status (100, 101, 102, 103) des mindestens einen Magnetsensors (11, 12, 21, 22, 31, 32) anzuzeigen.

8. Transportvorrichtung (5) nach Anspruch 7, wobei die Feststellungsvorrichtung (13, 14, 23, 24, 33, 34) an einem der Magnetsensoren (11, 12, 21, 22, 31, 32) angeordnet ist.

9. Transportvorrichtung (5) nach Anspruch 7 oder 8, wobei die Feststellungsvorrichtung (13, 14, 23, 24, 33, 34) dafür ausgelegt ist, anzuzeigen, ob der Magnetsensor (11, 12, 21, 22, 31, 32) defekt ist oder nicht.

10. Transportvorrichtung (5) nach einem der Ansprüche 7 bis 9, wobei die Feststellungsvorrichtung (13, 14, 23, 24, 33, 34) eine lichtemittierende Diode ist.

11. Transportvorrichtung (5) nach Anspruch 10, wobei die lichtemittierende Diode eine mehrfarbenlichtemittierende Diode ist und wobei jede Farbe der mehrfarbenlichtemittierenden Diode zum Anzeigen eines vorgegebenen Status (100, 101, 102, 103) des Magnetsensors (11, 12, 21, 22, 31, 32) verwendbar ist.

12. Maschine (1) zum Herstellen eines Artikels (2), die eine Transportvorrichtung (5) nach einem der vorherigen Ansprüche umfasst.

13. Maschine (1) nach Anspruch 12, wobei die Transportvorrichtung (5) zumindest teilweise in einem Vakuum angeordnet ist.

14. Transportverfahren für Transportträger (40) in einer Maschine (1), das die Schritte des Transportierens (S1) der Träger (40) durch die Anwendung einer Magnetkraft umfasst, die durch mindestens eine Magnetspule (10, 20, 30) erzeugt wird, des Feststellens (S2) der Funktion von einer der mindestens einen Magnetspule (10, 20, 30) mit mindestens einem Magnetsensor (11, 12, 21, 22, 31, 32) umfasst, der der einen Magnetspule (10, 20, 30) zugeordnet ist, und, mit mindestens einer Feststellungsvorrichtung (13, 14, 23, 24, 33, 34; 13-16; 23-26; 33-36), des Feststellens (S3) eines Status (100, 101, 102, 103) des mindestens einen Magnetsensors (11, 12, 21, 22, 31, 32) umfasst.

## Revendications

1. Appareil de transport (5) pour transporter des supports (40) dans une machine (1), comprenant au moins une bobine (10, 20, 30) pour transporter un support (40) en utilisant une force magnétique, et au moins un capteur magnétique (11, 12, 21, 22, 31, 32) affecté à l'une des au moins une bobines (10, 20, 30) et servant à détecter la fonction de la bobine (10, 20, 30) à laquelle il est affecté, au moins un dispositif de détection (13, 14, 23, 24, 33, 34 ; 13-16 ; 23-26, 33-36) étant connecté électriquement de manière à détecter un état (100, 101, 102, 103) de l'au moins un capteur magnétique (11, 12, 21, 22, 31, 32).

2. Appareil de transport (5) selon la revendication 1, dans lequel chacun des au moins un dispositifs de détection (13, 14, 23, 24, 33, 34 ; 13-16 ; 23-26 ; 33-36) est prévu pour détecter si le matériel du capteur magnétique (11, 12, 21, 31, 32) est cassé et/ou si l'alimentation électrique de la bobine (10, 20, 30) et/ou du capteur magnétique (11, 12, 21, 31, 32) est trop élevée ou trop basse.

3. Appareil de transport (5) selon la revendication 1 ou 2, dans lequel l'au moins un dispositif de détection (13, 14, 23, 24, 33, 34 ; 13-16 ; 23-26 ; 33-36) et/ou l'au moins un capteur magnétique (11, 12, 21, 31, 32) sont en outre prévus pour détecter la position de l'un des supports (40).

4. Appareil de transport (5) selon l'une quelconque des revendications précédentes, dans lequel deux capteurs magnétiques (11, 12, 21, 31, 32) et deux dispositifs de détection (13, 14, 23, 24, 33, 34) sont affectés à une bobine (10, 20, 30) des au moins une bobines (10, 20, 30).

5. Appareil de transport (5) selon l'une quelconque des revendications précédentes, dans lequel au moins un capteur magnétique (11, 12, 21, 31, 32) des au moins un capteurs magnétiques (11, 12, 21, 31, 32) est un capteur de Hall.

6. Appareil de transport (5) selon l'une quelconque des revendications précédentes, dans lequel le capteur magnétique (11, 12, 21, 31, 32) comprend deux capteurs de Hall et dans lequel les deux capteurs de Hall sont connectés électriquement sous la forme du dispositif de détection (15, 16, 25, 26, 35, 36) et sont capables de détecter la position d'un support (40).

7. Appareil de transport (5) selon l'une quelconque des revendications précédentes, dans lequel le dispositif de détection (13, 14, 23, 24, 33, 34) est capable d'afficher l'état (100, 101, 102, 103) de l'au moins un capteur magnétique (11, 12, 21, 31, 32).

8. Appareil de transport (5) selon la revendication 7, dans lequel le dispositif de détection (13, 14, 23, 24, 33, 34) est prévu au niveau de l'un des capteurs magnétiques (11, 12, 21, 31, 32).

9. Appareil de transport (5) selon la revendication 7 ou 8, dans lequel le dispositif de détection (13, 14, 23, 24, 33, 34) est prévu pour afficher si le capteur magnétique (11, 12, 21, 31, 32) présente un défaut de fonctionnement ou pas.

10. Appareil de transport (5) selon l'une quelconque des revendications 7 à 9, dans lequel le dispositif de détection (13, 14, 23, 24, 33, 34) est une diode électroluminescente.

11. Appareil de transport (5) selon la revendication 10, dans lequel la diode électroluminescente est une diode émettant de la lumière multicolore et dans lequel chaque couleur de la diode émettant de la lumière multicolore peut être utilisée pour afficher un état prédéterminé (100, 101, 102, 103) du capteur magnétique (11, 12, 21, 31, 32).

12. Machine (1) destinée à produire un article (2), comprenant un appareil de transport (5) selon l'une quelconque des revendications précédentes.

13. Machine (1) selon la revendication 12, dans laquelle l'appareil de transport (5) est au moins en partie disposé dans un vide.

14. Procédé de transport pour transporter des supports (40) dans une machine (1), comprenant les étapes consistant à transporter (S1) les supports (40) en utilisant une force magnétique produite par au moins une bobine (10, 20, 30), détecter (S2) la fonction de l'une des au moins une bobines (10, 20, 30) avec au moins un capteur magnétique (11, 12, 21, 31, 32) affecté à ladite une bobine (10, 20, 30), et détecter (S3) avec au moins un dispositif de détection (13, 14, 23, 24, 33, 34 ; 13-16 ; 23-26 ; 33-36) un état (100, 101, 102, 103) de l'au moins un capteur magnétique (11, 12, 21, 31, 32).
